# EUROPEAN PATENT APPLICATION

(11) **EP 0 534 240 A1**
(43) Date of publication of application: **31.03.1993**
(21) Application number: 92115514.9
(22) Date of filing: 10.09.1992
(51) Int. Cl.: C23F 1/20, H01L 21/336, H01L 21/321

(54) **Method for etching metal thin film consisting essentially of aluminum and for producing thin film transistor**

(30) Priority: 24.09.1991 JP 243090/91
(71) Applicant: MATSUSHITA ELECTRIC INDUSTRIAL CO., LTD., Kadoma-shi, Osaka-fu, 571 (JP)
(72) Inventor: Tsutsu, Hiroshi, Ithaca, New York 14850 (US)
(74) Representative: Jung, Elisabeth, Dr.

(57) **Abstract**

Metal thin film consisting essentially of aluminum is etched with an etching liquid containing at least fluoric acid and no smaller than 10% of nitric acid, and the etched metal thin film has a peripheral edge having a beveled cross-sectional profiles of the desired positive (non-overhanging) tapering angle. The buried lower-layer thin lead conductors on an insulator substrate is etched by this etching liquid, and the beveled cross-sectional profiles ensure a low reject rate of disconnection of the lead conductor in the wiring at upper layer.

## Description

### FIELD OF THE INVENTION AND RELATED ART STATEMENT

### 1. FIELD OF THE INVENTION

The present invention relates to a method for etching metal thin film. More particularly, it is concerned with a method for selectively etching away a metal thin film consisting essentially of aluminum, which is in general use as a material for lead conductor in a semiconductor device.

### 2. DESCRIPTION OF THE RELATED ART

Pure aluminum or metals consisting essentially of aluminum with a small amount of impurity such as silicon or copper have very small electric resistance and are in general use as a material for lead conductors in semiconductor devices. The lead conductor representing a wiring pattern has conventionally been usually formed in such a process of: first depositing the metal as a thin film on the substrate by means of sputtering or the like, creating a desired photoresist pattern by means of photolithography, removing the UV-exposed part of the metal thin film by means of wet-etching with a phosphoric acid (H₃PO₄) solution or by means of dry-etching with a reactive gas of boron trichloride (BCl₃) or chlorine (Cl₂), and finally removing the remained photoresist pattern.

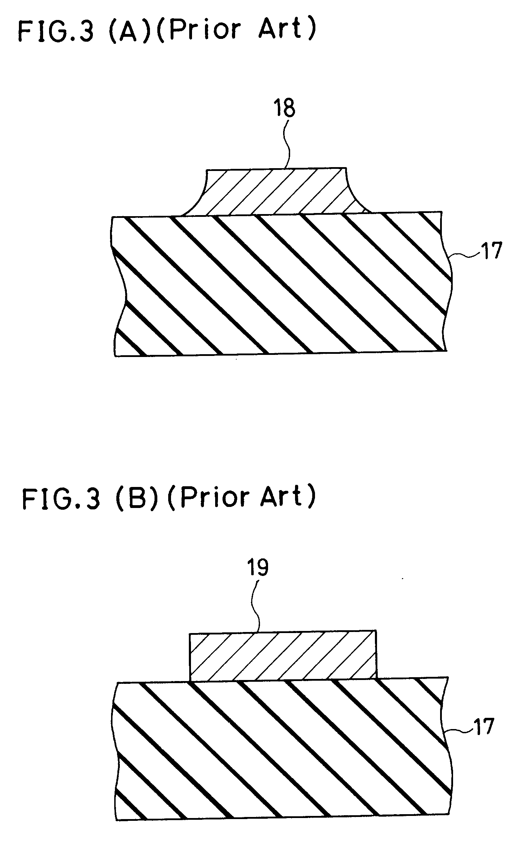

Since the conventional wet-etching utilizing phosphoric acid or the like usually results in an isotropic etched region, the cross-section of beveled periphery of the metal (Al) thin film 18 takes an arcuate concaved profile shown by FIG.3(A), wherein numeral 17 represents a substrate. On the other hand, the dry-etching generally results in an anisotropically etched region depending on the exerted gas pressure or the consumed energy. And the cross-section of the etched region takes a rectangular profile as shown by FIG.3(B), wherein numeral 19 represents the aluminum thin film dry-etched with boron trichloride (BCl₃) and chlorine (Cl₂).

In general, a multi-layered wirings comprising two or more lead conductor layers are often installed on a semiconductor device with elements such as transistor. In particular, in the case of an active matrix liquid display device provided with a matrix of switching transistors, the wirings in two directions of X and Y are indispensable. In order to obtain a large picture face composed of a multiplicity of pixels with least delay in signal transmission, the lead conductors used for the wiring is required to have electric resistances as small as possible.

If the above-mentioned etched metal thin film with the arcuate concaved cross-section is employed as a wiring for the uppermost layer of the multi-layered device, there is no problems whether its cross-sectional profile may be any of those shown in FIGs.3 (A) and (B). In case where a buried etched aluminum thin film for the wiring is used in a substratum of a device in order to minimize delay of signal transmission, it is, however, required to form an insulator layer over the buried aluminum wiring in the substratum by some means. In such device, it is further required to provide the upper layer wiring over the insulator layer.

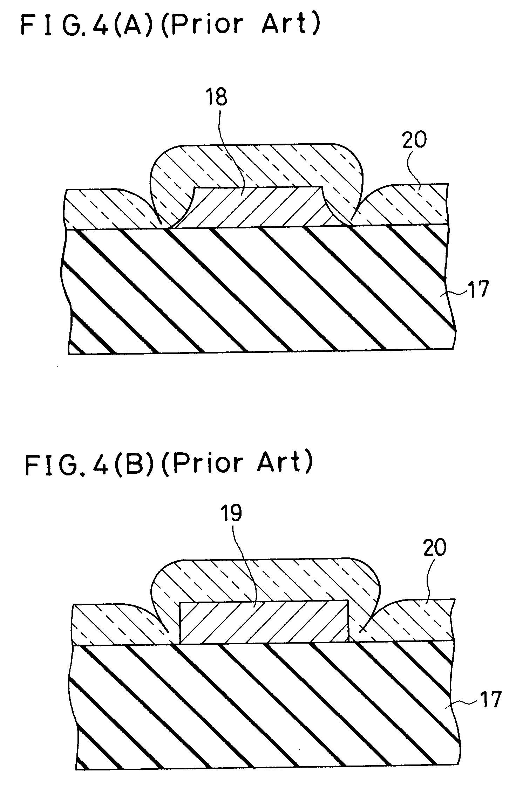

Namely, in the conventional cases, the cross-sectional profiles of the aluminum lead conductors (18 and 19) buried in the substratum layer are those shown by FIGs.3 (A) and (B). Then, the cross-sectional profiles of the insulator layers (20) piled up over the wiring usually become "stepped-coverages" shape as shown by FIGs.4 (a) and (B), respectively. Since the stepped coverage results in an insufficient insulating performance at a crack developed along a constricted part of the insulator layer between the steps, it has a problem in that a disconnection may often be induced in the lead conductor of the upper layer, or a short circuit might be developed between both the lead conductors of the upper layer and of the substratum. This may also occur in the cases wherein the insulator layer is a metal oxide layer formed by anodizing the substratum metal.

Japanese Unexamined Patent Publication (Tokkai)Hei 2-2636 discloses a method for producing a thin film transistor alley. This disclosure relates to a method, wherein the thin film transistor, which comprises a gate (exemplified as Al-Cr), a gate insulating film (exemplified as SiNₓ), an amorphous silicon layer, a source electrode and a drain electrode (exemplified as Al-Cr), all being deposited on an insulator substrate, is produced by thin film technology. This method is characterized in that both of said gate insulating layer and said amorphous silicon layer are etched in a plasma etching process with a gas containing fluorine to render beveled edges into triangular cross-sectional profiles.

Although the configuration of the produced transistor is similar to that obtained by the present invention, the gate which also serves as a lead conductor expanding biaxially over the substrate of the alley is shown to have a cross-sectional profile of rectangular, as opposed to that of triangular provided by the present invention. Further, the disclosure is primarily directed to a beveled-profile etching of the SiNₓ layer and that of the amorphous silicon layer, but is silent about the manner for forming the gate of Al-Cr.

Another etching liquid for the Al-Si alloy is disclosed in Japanese Unexamined Patent Publication (Tokkai)Sho 62-211391, consisting of phosphoric acid, nitric acid, fluoric acid and water. Although the disclosure relates to the beveled cross-sectional profile of the etched Al-Si thin film and its very small etching residue, it is silent about the use of the etching liquid containing no phosphoric acid of the present invention.

Thus, the above-stated problem cannot be solved by the methods of these prior art.

### OBJECT AND SUMMARY OF THE INVENTION

It is therefore the primary object of the present invention to provide a method for etching a metal thin film consisting essentially of aluminum formed on a substrate, which method is capable of controlling a cross-sectional profile of the peripheral region of the metal thin film triangular.

It is another object of the present invention to provide a method for manufacturing a semiconductor device. The manufactured semiconductor device is free from the disconnection of the lead conductor in the wiring at upper layer and the short circuit between the lead conductors in the wirings at upper layer and that in the substratum of the multi-layered deposited semiconductor device. The stated semiconductor device can be manufactured in a low reject rate and is excellent in its reliability.

According to the present invention there is provided in the method for etching metal thin film consisting essentially of aluminum, a method which comprises a use of an etching liquid containing at least fluoric acid and 10% or more nitric acid.

In the above-mentioned method, said etching liquid is preferably an aqueous solution containing fluoric acid, acetic acid and nitric acid. Said aqueous solution may contain nitric acid (60% conc.), acetic acid, water and fluoric acid (50% conc.) in a volumetric ratio of 50 : 25 : 25 : 2.

In addition to these, said metal thin film may consist of pure aluminum or aluminum containing silicon, copper, platinum, palladium and/or titanium, as additive. In the case of Al-Si alloy, it may contain silicon in 0.5 -- 2.0% together with the balance of aluminum. According to another aspect of the present invention, there is provided in the method for producing a thin film transistor which includes at least:
a first step of forming a first conductive layer by selectively depositing an electrically conductive material on a transparent insulator substrate;
a second step of covering said first conductive layer and exposed surfaces of said substrate with an insulator layer;
a third step of covering specified regions of said insulator layer with a semiconductor layer;
a fourth step of forming a pair of second conductive layers which are partly superimposed on said semiconductor layer; and
a fifth step of forming a transparent conductive layer which is in electrical contact with one of the pair of said conductive layers;
a method whose said first step comprises:
a first sub-step of depositing a metal thin film consisting essentially of aluminum over the whole surface of said transparent insulator substrate;
a second sub-step of forming a desired photoresist pattern on said metal thin film; and
a third sub-step of selectively removing a part of said metal thin film by etching said metal thin film by a mixed solution containing at least fluoric acid and 10% or more nitric acid.

In the thin film transistor manufacture by the above-mentioned method, said transparent insulator substrate is preferably a glass plate. Said electrically conducting material is preferably a metal consisting essentially of aluminum. Said metal may contain silicon, copper, platinum and/or titanium as additive(s). In the case of Al-Si alloy, it preferably contain silicon in 0.5 -- 2.0% together with the balance of aluminum.

In addition to these, said insulator layer is preferably a silicon nitride film. Said semiconductor layer is preferably composed of amorphous silicon. Said second conductive layer is preferably a metal containing silicon in 0.5 -- 2.0% together with the balance of aluminum. Said second conductive layer may alternatively be a metal silicide such as molybdenum silicide. Further, said second conductive layer may be a metal such as pure aluminum, chromium, molybdenum, tantalum, nickel or nickel-chromium alloy.

In the above-mentioned thin film transistor, said gate insulator layer is preferably silicon nitride (SiNₓ). Said gate insulator layer may alternatively be a metal oxide, which is composed essentially of aluminum oxide and formed by anodizing said gate of aluminum alloy. In the case of the anodized gate insulator layer, a silicon nitride (SiNₓ) is preferably deposited on the metal oxide layer to provide a double insulation.

In accordance with the above-stated etching method, the cross-sectional profile of the peripheral region of the metal thin film can be controlled, because the adhesivity of the photoresist depends on the concentration of nitric acid in the etching liquid.

According to the above-stated manufacturing method, such a semiconductor device of excellent reliability can be manufactured in a low reject rate that which is free from the disconnection of the lead conductor in the wiring at upper layer and the short circuit between the lead conductors in the wirings at upper layer and that in the substratum of the multi-layered deposited semiconductor device. Further, since such impurity as silicon or the like, which is often added to the metal thin film for preventing migration or hillock therein, can also be etched together with the aluminum, there is very small etching residue.

While the novel features of the present invention are set fourth particularly in the appended claims, the invention, both as to organization and content, will be better understood and appreciated, along with other objects and features thereof, from the following detailed description taken in conjunction with the drawings.

### BRIEF DESCRIPTION OF THE DRAWINGS

FIG.1(A) is a schematic cross-sectional view illustrating the initial steps of the etching process performed in accordance with the present invention.

FIG.1(B) is a schematic cross-sectional view illustrating the steps of the etching process following the steps shown in (A).

FIG.1(C) is a schematic cross-sectional view illustrating the steps of the etching process following the step shown in (B).

FIG.2(A) is a schematic cross-sectional view illustrating the initial steps of the etching process in accordance with the present invention applied to the production of a reverse-staggered thin film transistor. FIG.2(B) is a schematic cross-sectional view illustrating the steps of the production method following the steps shown in (A).

FIG.2(C) is a schematic cross-sectional view illustrating the steps of the production method following the step shown in (B).

FIG.2(D) is a schematic cross-sectional view illustrating the steps of the production method following the steps shown in (C).

FIG.2(E) is a schematic cross-sectional view illustrating the steps of the production method following the step shown in (D).

FIG.2(F) is a schematic cross-sectional view illustrating the steps of the production method following the step shown in (E).

FIG.3(A) is a schematic cross-sectional view illustrating an aluminum thin film deposited on a substrate and etched in the conventional wet process. FIG.3(B) is a schematic cross-sectional view illustrating an aluminum thin film deposited on a substrate and etched in the conventional dry process.

FIG.4(A) is a schematic cross-sectional view illustrating a thin film deposited on a substrate and etched by the conventional wet process, and then covered with an insulating layer.

FIG.4(B) is a schematic cross-sectional view illustrating a thin film deposited on a substrate and etched by the conventional dry process, and then covered with an insulating layer.

### DESCRIPTION OF THE PREFERRED EMBODIMENTS

In the following paragraphs, the present invention will be described in more detail with reference to the preferred embodiments shown in the attached drawings.

### WORKING EXAMPLE 1.

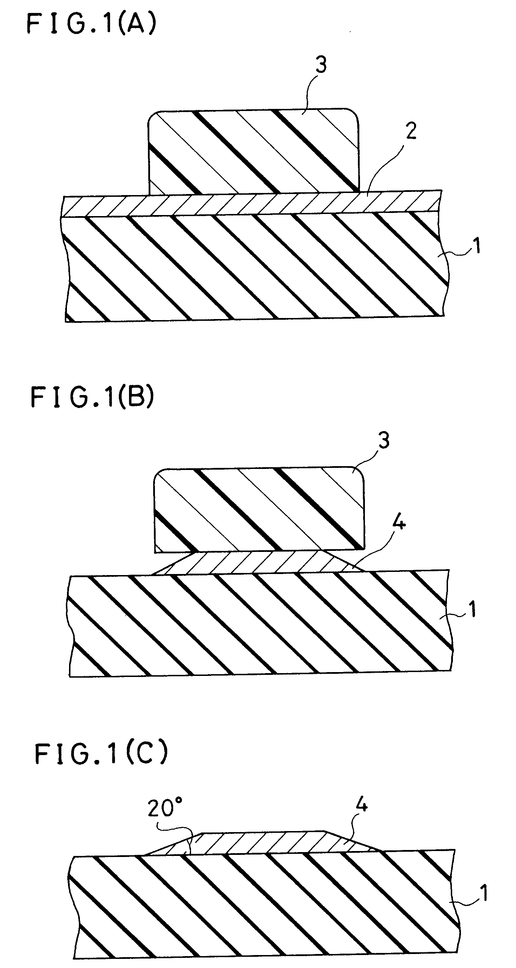

Each of FIG.1 inclusively shows elevation cross-sections of substrate at the respective steps in the method performed in accordance with the present invention.

In FIG.1(A), a thin film 2 of aluminum containing about 0.5 --- 2.0% of silicon as an impurity, which is added in order to prevent the migration or hillock attributable to heat or mechanical stress, was piled up for 200 nm film thickness over the whole surface of a substrate 1. The method employed for the piling-up was one of sputtering and electron beam deposition.

Then, a photoresist layer 3 having a desired planer pattern (not shown) was formed on the aluminum thin film 2 by means of the conventional photolithography. In this example, a post-baking on the photoresist layer was performed at 130°C. This temperature of the post-baking has a great influence on the tapered profile of the beveled edge of the aluminum thin film.

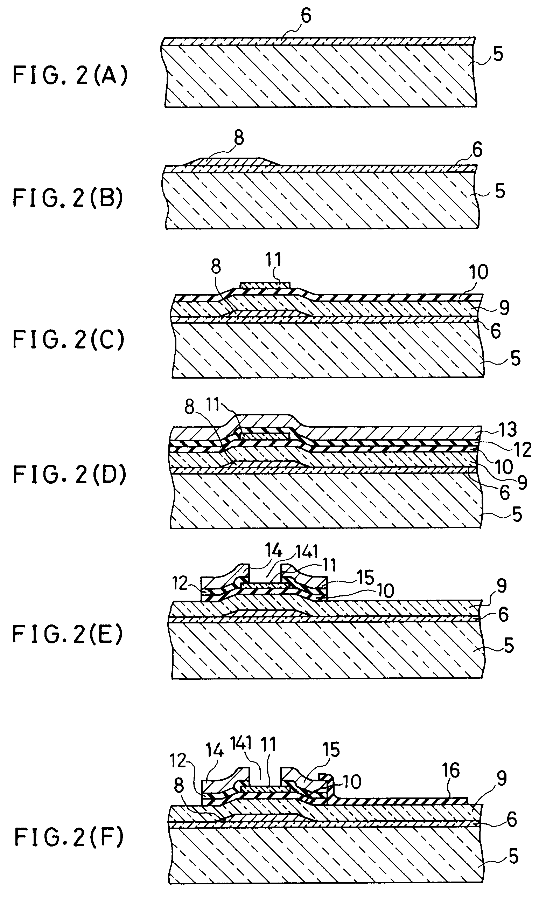

Thereafter, the part of the aluminum thin film 2 which was not covered with the photoresist layer 3 was etched as shown in FIG.2(B) with an etching liquid prepared by mixing aqueous nitric acid (HNO₃) of 60% conc., acetic acid (CH₃COOH), water (H₂O) and aqueous fluoric acid (HF) of 50% conc. in a volumetric ratio of 50 : 25 : 25 : 2 at room temperature. In the etching with this etching liquid, the terminal point for the process sufficient for etching aluminum in the film as thick as 200 nm is said to be in about 40 second. However, the actual process was completed at about 45 second with an over-etching of about 10%.

With the removal of the photoresist layer 3 in a conventional manner, an etched aluminum thin film 4 having the desired planer pattern was left on the substrate 1. The edge of the aluminum thin film 4 had a beveled profile with about 20^{o} tapering angle as shown by FIG.1(C).

In this Working Example, the aluminum containing silicon was used for the material for the thin film though, pure aluminum, and an aluminum containing copper, platinum, palladium or titanium may also be employed with the same advantage. Further, although the etching liquid of HNO₃ (60%) : CH₃COOH):H₂O : HF (50%) = 50 : 25 : 25 : 2 was employed in this Working Example, the resulting tapering angle of the beveled edge of the thin film can be controlled as desired by varying the concentration of the nitric acid and/or fluoric acid in the etching liquid.

### WORKING EXAMPLE 2.

Each of the cross-sectional views of FIG.3 shows the cross-sectional elevation view obtained in each of the steps of this Working Example performed in accordance with the second aspect of the present invention. In this Working Example 2, a thin film transistor of reverse-staggered type formed on a transparent substrate was produced for application to the liquid crystal display or the like apparatus.

The transparent insulator substrate 5 in FIG.2(A) is preferably a glass plate in view of the manufacturing cost of the device. At first, a tantalum oxide film 6 was deposited over the whole surface of the amorphous insulator substrate 5 by sputtering. The tantalum oxide film 6 is for preventing the diffusion and precipitation of impurity atoms from the glass substrate and the damage of the glass substrate itself attributable to the etching process in accordance with the present invention.

Then, an aluminum thin film containing 0.5 --2.0% of silicon was deposited with a thickness of 200 nm over the whole surface of the tantalum oxide layer 6. The silicon was added as an impurity for preventing the migration and/or hillock of aluminum. The aluminum thin film was covered with a photoresist layer, which was then irradiated with a light of the desired image pattern. Thereafter the irradiated photoresist layer was etched selectively to leave an aluminum gate 8 having a beveled edge of tapering angle of 20° as shown in FIG.2(B), in the same manner as that described in the Working Example 1.

Next, a silicon nitride (SiNₓ) film 9 which serves as a gate insulator layer and an intrinsic amorphous silicon (a-Si) film 10 for serving as an active semiconductor layer were continuously deposited on the whole surfaces of the tantalum oxide film 6 and the over-riding aluminum gate 8, by a plasma CVD (chemical vapor deposition) method. And then, a second silicon nitride (SiNₓ) film 11 was formed over the whole surfaces of the amorphous silicon film 10, followed by known patterning and selective etching to form the silicon nitride film 11 into a strip-shaped etching stopper 11 as shown in FIG.2(C).

Then, a film 12 of amorphous silicon doped with phosphor as an n-type impurity (n⁺-a-Si) was deposited over the whole surfaces of the intrinsic amorphous silicon film 10 and the overriding SiNₓ etching stopper 11. Then, a gate lead-out opening (not shown because it is disposed in front of the plane of paper of FIG.2(D)) is made by known photolithographic etching, to expose a part of the gate aluminum film 8. Thereafter, a titanium (Ti) film 13 is formed over the whole surface of the n⁺-a-Si 12 as shown in FIG.2(D). The n⁺-a-Si film layer 12 serves to make good ohmic contact between the underlying intrinsic amorphous layer 10 and the overriding Ti film 13.

Thereafter, photoresist patterning (not shown) is formed so as to make the source electrode 14 and the drain electrode 15 from the Ti film 13. The source electrode 14 and the drain electrode 15 are formed by known selective etching using the photoresist pattern.

In the chemical etching to form the source electrode 14 and the drain electrode 15, the slit 141 is formed by boring in the Ti film 13 and the underlying n⁺-a-Si film 12 with the photoresist pattern. The etching of the slit 141 is stopped by the second silicon nitride film 11. Thus the source electrode 14 and the drain electrode 15 are formed as shown by FIG.2(E).

Finally, a film 16 of ITO (indium-tin oxide) which serves as a transparent electrode is deposited over the whole substrate and selectively etched in a manner that it can be in an electrical contact with the drain electrode 15 to complete the thin film transistor as shown by FIG.2(F).

In this Working Example 2, silicon-containing aluminum was used as the material for the gate 8, though, any of pure aluminum, aluminum added with copper, platinum, titanium and the like may also be employed with the same advantage. Further, although titanium (Ti) was used as the material for the source and drain, it is possible to employ a metal silicide such as molybdenum silicide, and another metal such as aluminum. chromium, molybdenum, tantalum, nickel, nickel-chromium alloy.

The above-mentioned steps for forming a transparent electrode may be omitted, when a transparent conducting film such as ITO, stannic oxide or the like is used as a material for forming the source and/or drain. further, the forming of transparent electrode is not necessarily placed at the final step of the process for producing thin film transistor. But the transparent electrode may alternatively formed in one of the initial steps and the electrical contact with the drain may be realized by providing an opening through the insulating layer.

In addition to this, although forming of SiNₓ by the plasma CVD method was used for forming the gate insulating layer, the gate insulating layer may be aluminum oxide film formed by anodizing the aluminum of the gate. In such a case, said anodized aluminum oxide layer and the SiNₓ by the plasma CVD method may be employed together as a double gate insulating layer in order to reduce the shortcircuiting attributable to pinholes in the gate insulating layer.

Although the above description of the preferred embodiment is limited to the thin film transistor, the method according to the present invention is also applicable to an element exploiting the thin film technology such as bipolar transistor, hetero junction bipolar transistor and the like semiconductor device.

Although the present invention has been described in terms of the presently preferred embodiments, it is to be understood that such disclosure is not to be interpreted as limiting. Various alterations and modifications will no doubt become apparent to those skilled in the art to which the present invention pertains, after having read the above disclosure. Accordingly, it is intended that the appended claims be interpreted as covering all alterations and modifications as fall within the true spirit and scope of the invention.

## Claims

1. In the method for etching metal thin film consisting essentially of aluminum,
a method which comprises a use of an etching liquid containing at least fluoric acid and 10% or more nitric acid.

2. The method for etching metal thin film in accordance with claim 1, wherein
said etching liquid is an aqueous solution containing fluoric acid, acetic acid and nitric acid.

3. The method for etching metal thin film in accordance with claim 2, wherein
said aqueous solution contains 60% conc. nitric acid, acetic acid, water and 50% conc. fluoric acid in a volumetric ratio of 50 : 25 : 25 : 2.

4. The method for etching metal thin film in accordance with claim 1, 2 or 3, wherein
said metal thin film consists of pure aluminum.

5. The method for etching metal thin film in accordance with claim 1, 2 or 3, wherein
said metal thin film contains silicon, copper, platinum, palladium and/or titanium as additive(s).

6. The method for etching metal thin film in accordance with claim 5, wherein
said metal thin film contains silicon in 0.5 --2.0 % together with the balance of aluminum.

7. In the method for producing a thin film transistor which includes at least:
a first step of forming a first conductive layer by selectively depositing an electrically conductive material on a transparent insulator substrate;
a second step of covering said first conductive layer and exposed surfaces of said substrate with an insulator layer;
a third step of covering specified regions of said insulator layer with a semiconductor layer;
a fourth step of forming a pair of second conductive layers which are partly superimposed on said semiconductor layer; and
a fifth step of forming a transparent conductive layer which is in electrical contact with one of the pair of said second conductive layers;
a method whose said first step comprises:
a first sub-step of depositing a metal thin film consisting essentially of aluminum over the whole surface of said transparent insulator substrate;
a second sub-step of forming a desired photoresist pattern on said metal thin film; and
a third sub-step of selectively removing a part of said metal thin film by etching said metal thin film by a mixed solution containing at least fluoric acid and 10% or more nitric acid.

8. The method for producing a thin film transistor in accordance with claim 7, wherein
said transparent insulator substrate is a glass plate.

9. The method for producing a thin film transistor in accordance with claim 7, wherein
said electrically conducting material is a metal consisting essentially of aluminum.

10. The method for producing a thin film transistor in accordance with claim 9, wherein
said metal contains silicon, copper, platinum and/or titanium in addition to aluminum.

11. The method for producing a thin film transistor in accordance with claim 10, wherein
said metal contains silicon in 0.5 -- 2.0% together with the balance of aluminum.

12. The method for producing a thin film transistor in accordance with claim 7, wherein
said insulator layer is silicon nitride film.

13. The method for producing a thin film transistor in accordance with claim 7, wherein
said semiconductor layer is composed of amorphous silicon.

14. The method for producing a thin film transistor in accordance with claim 7, wherein
said second conductive layer is a metal containing silicon in 0.5 -- 2.0% together with the balance of aluminum.

15. The method for producing a thin film transistor in accordance with claim 7, wherein
said second conductive layer is a metal silicide such as molybdenum silicide.

16. The method for producing a thin film transistor in accordance with claim 7, wherein
said second conductive layer is a metal such as aluminum, chromium, molybdenum, tantalum, nickel or nickel-chromium alloy.

17. The method for producing a thin film transistor in accordance with claim 7, wherein
said gate insulator layer contains silicon nitride (SiNₓ).

18. The method for producing a thin film transistor in accordance with claim 7, wherein
said gate insulator layer is a metal oxide composed essentially of aluminum oxide and formed by anodizing said gate of aluminum alloy.

19. The method for producing a thin film transistor in accordance with claim 18, wherein
said gate insulator layer is composed of said metal oxide and a silicon nitride (SiNₓ) deposited on said metal oxide layer.
